# EUROPEAN PATENT APPLICATION

(11) **EP 0 851 714 A2**
(43) Date of publication of application: **01.07.1998**
(21) Application number: 97310509.1
(22) Date of filing: 23.12.1997
(51) Int. Cl.: H05B 33/12, H05B 33/10, H05B 33/14

(54) **Donor film for organic thin film of organic electroluminescence device, and method for manufacturing organic electroluminescence device using the same**

(30) Priority: 23.12.1996 KR 9670731
(71) Applicant: SAMSUNG DISPLAY DEVICES CO., LTD., Suwon-city, Kyungki-do 442-390 (KR)
(72) Inventor: Kwon, Jang-hyuk, Changan-gu, Suwon-city, Kyungki-do (KR); Lee, Si-hyun, Changan-gu, Suwon-city, Kyungki-do (KR); Park, Joo-sang, Changan-gu, Suwon-city, Kyungki-do (KR); Kim, Lee-gon, Changan-gu, Suwon-city, Kyungki-do (KR)
(74) Representative: Kyle, Diana

(57) **Abstract**

A donor film for an organic thin film of an organic electroluminescence device (EL device), and a method for manufacturing an organic EL device using the same. The donor film includes a base film, a light-absorbing layer formed on the base film, and a transfer layer formed on the light-absorbing layer. The transfer layer is formed of a luminous material, a hole transfer low molecular weight compound, a hole transfer high molecular weight compound, an electron transfer low molecular weight compound or an electron transfer high molecular weight compound, and the luminous material is an organic electroluminescence layer, an organometallic complex electroluminescence material or an electroluminescence polymer. Therefore, excellent, finely patterned organic thin films for an organic EL device can be formed. In addition, fine patterns of red, green and blue pixels can be formed, thereby providing full color displaying and a high quality organic EL device.

## Description

### BACKGROUND OF THE INVENTION

### 1. Field of the Invention

The present invention relates to a method for manufacturing an organic electroluminescence (EL) device, and more particularly, to a donor film, which is used to form an organic thin film pattern using a laser transfer method, and a method for manufacturing an organic EL device.

### 2. Description of the Related Art

In general, it is easy to manufacture an EL device, and the EL device is capable of being mass-produced, and driven at a low voltage. In addition, the EL device can be made thin. Due to these merits, the EL device has been the focus of next generation displays.

The EL device is manufactured as follows.

First, a first electrode layer and an emission layer are formed in sequence on a transparent substrate made of glass or transparent polymer. After forming a second electrode layer on the emission layer, an insulation film is then formed thereon, completing the EL device.

In the EL device, an electrical field is formed by applying a voltage on an electrode, so that the emission layer emits light, forming an image.

The EL device is classified into an inorganic EL device and an organic EL device depending on the material used for the emission layer.

The organic EL device has excellent luminance, driving voltage and response rate, and can display a multitude of colors. Thus, research into the organic EL device has been more actively conducted than the inorganic EL device.

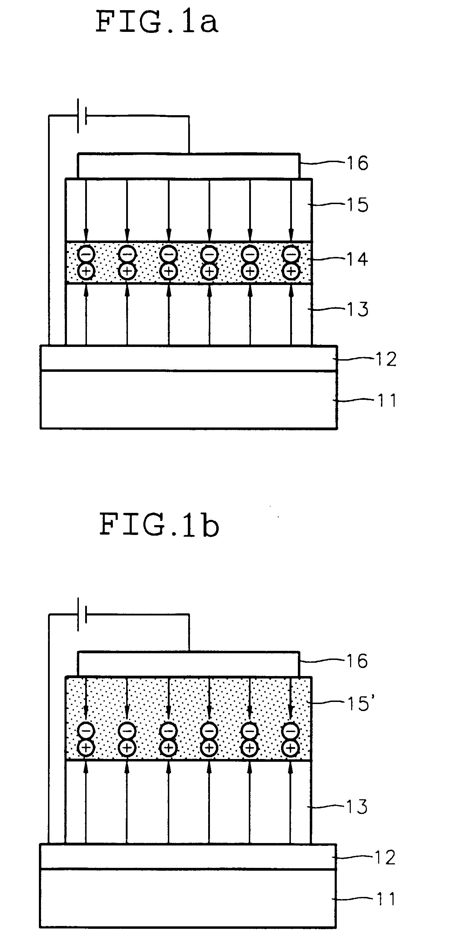

FIG. 1A is a diagram showing the structure of a general organic EL device. Referring to FIG. 1A, a first electrode layer 12, a hole transport layer 13, an emission layer 14, an electron transport layer 15 and a second electrode layer 16 are formed in sequence the first electrode layer 12. Here, the hole transport layer 13, the emission layer 14 and the electron transport layer 15 are organic thin films and the second electrode layer 16 is not.

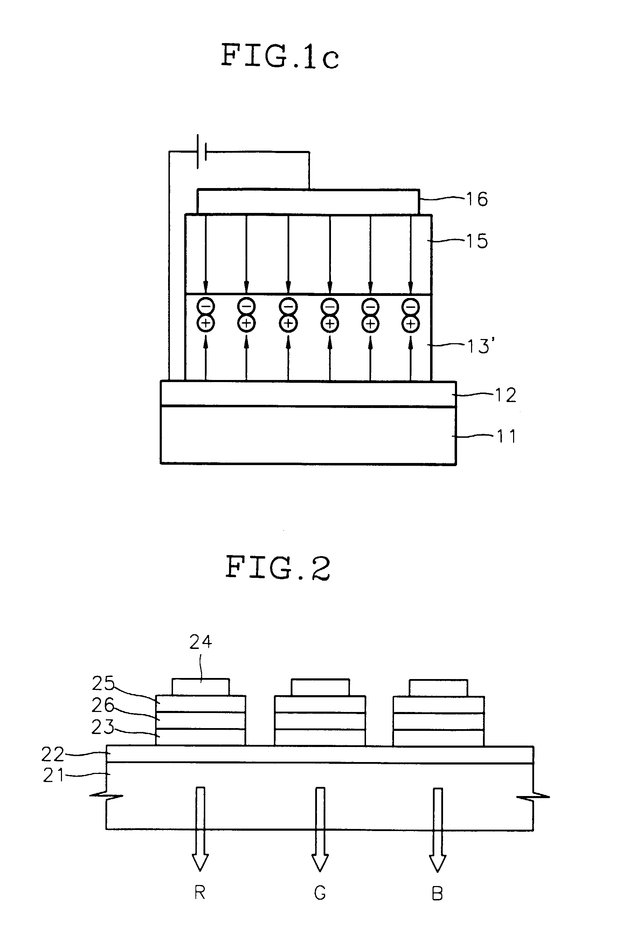

Recently, a new EL device having a modified structure from the basic structure of FIG. 1A has been developed. The structure of this organic EL device is shown in FIGs. 1B and 1C.

The organic EL device shown in FIG. 1B has a structure in which a first electrode layer 12, a hole transport layer 13, an electron transport emission layer 15' and a second electrode layer 16 are formed in sequence on a substrate 11. Also, the organic EL device shown in FIG. 1C has a structure in which a first electrode layer 12, a hole transport emission layer 13', an electron transfer layer 15 and a second electrode layer 16 are formed in sequence on a substrate 11.

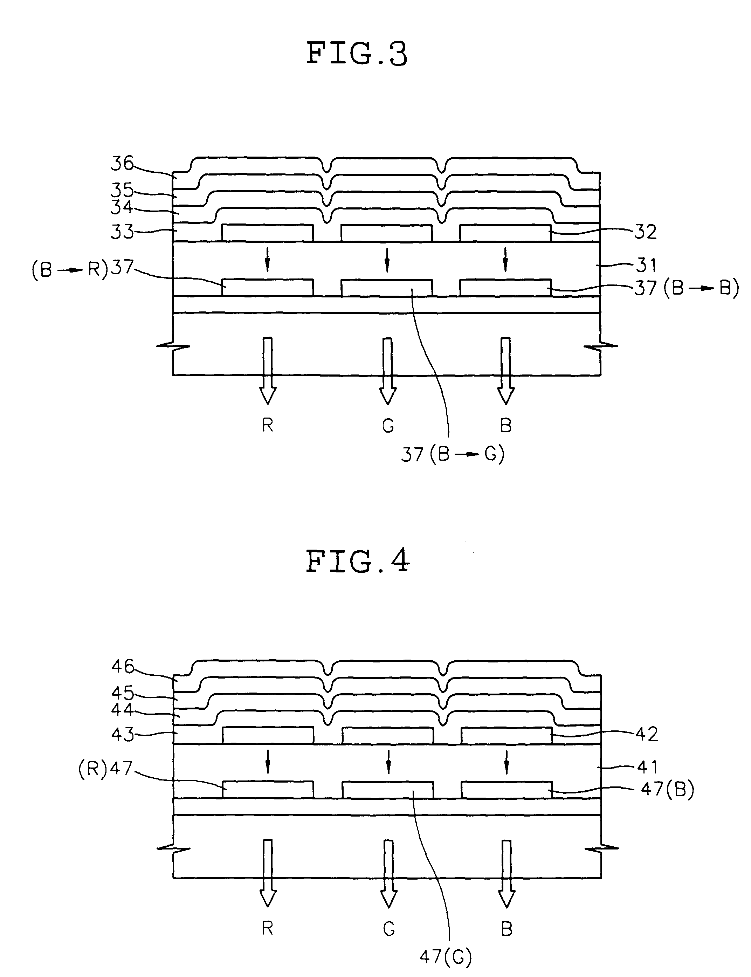

FIGs. 2, 3 and 4 are sectional views showing the structure of color organic EL devices. Particularly, the organic EL device shown in FIG. 2 includes a red (R), green (G) and blue (B) emission layer 26 as color display means. Also, as the color display means, the organic EL device of FIG. 3 adopts a color conversion layer 37, and the organic EL device of FIG. 4 adopts a color filter 47, respectively.

However, such color organic EL devices are not capable of full color display. The reason for this is because it is difficult to form fine patterns of organic thin films such as emission layer, electron transport layer and hole transport layer.

As a method for forming a pattern of an organic thin film, there is a photolithography process in which the organic thin film is finely patterned using a photoresist pattern which is obtained by coating photoresist on the organic thin film, and exposing and then developing the resultant structure.

However, according to the photolithography method, the thin films are degraded by organic solvent and developing solution residues used for the photolithography process. Thus, it is impossible to adopt the photolithography method.

As another method, there is a vacuum deposition method using a mask. However, it is difficult to apply this method to obtain a fine pattern of tens micrometer in width.

### SUMMARY OF THE INVENTION

To solve the above problems, it is an object of the present invention to provide a donor film for an organic thin film of an organic electroluminescence (EL) device, which is capable of achieving a full color display by forming organic thin films having a fine pattern.

It is another object of the present invention to provide a method for manufacturing an organic EL device using the above donor film.

To achieve the first object, there is provided a donor film for an organic thin film of an organic electroluminescence (EL) device, comprising:
a base film;
a light-absorbing layer formed on the base film; and
a transfer layer formed on the light-absorbing layer,
wherein the transfer layer is formed of at least one material selected from the group consisting of a luminous material, a hole transfer low molecular weight compound, a hole transfer high molecular weight compound, an electron transfer low molecular weight compound and an electron transfer high molecular weight compound, the luminous material being selected from the group consisting of an organic electroluminescence material, an organometallic complex electroluminescence material and an electroluminescence polymer.

To achieve the second object, there is provided a method for manufacturing an organic electroluminescence (EL) device, comprising the steps of:
(a) forming a first electrode layer on a substrate;
(b) arranging a donor film comprising a base film, a light-absorbing layer and a transfer layer in a position separated by a predetermined distance from the substrate having the first electrode layer, the transfer layer being formed of at least one transfer material selected from the group consisting of a luminous material, a hole transfer low molecular weight compound, a hole transfer high molecular weight compound, an electron transfer low molecular weight compound and an electron transfer high molecular weight compound, the luminous material being selected from the group consisting of an organic electroluminescence material, an organometallic complex electroluminescence material and an electroluminescence polymer;
(c) irradiating a light source onto the base film of the donor film to transfer at least one transfer material onto the substrate from the transfer layer, to form an objective layer corresponding to the selected transfer material; and
(d) forming a second electrode layer on the resultant.

### BRIEF DESCRIPTION OF THE DRAWINGS

The above objects and advantages of the present invention will become more apparent by describing in detail a preferred embodiment thereof with reference to the attached drawings in which:
FIG. 1A is a diagram showing the structure of a general organic electroluminescence (EL) device;
FIGs. 1B and 1C are diagrams showing the structure of modified organic EL devices;
FIG. 2 is a diagram showing the structure of a color organic EL device adopting a three-color emission layer as a color display layer;
FIG. 3 is a diagram showing the structure of a color organic EL device adopting a color conversion layer as a color display layer;
FIG. 4 is a diagram showing the structure of a color organic EL device adopting a color filter as a color display layer;
FIG. 5 is a diagram showing the structure of a donor film for an organic thin film of an organic EL device according to the present invention; and
FIG. 6 is a diagram illustrating a method for manufacturing an organic EL device adopting a donor film according to the present invention.

### DESCRIPTION OF THE PREFERRED EMBODIMENT(S)

According to the present invention, a laser transfer technology is applied to form a fine pattern for an organic thin film of an organic electroluminescence (EL) device.

A laser transfer method is widely used in the fields of printing, typesetting, photography and the like. This method utilizes a principle in which an object material is transferred to a receptor by propelling the object material from a donor film having a layer made of the object material to be transferred to the receptor.

Since a lot of energy is required in transferring the object material to the receptor, there is a need for a donor film enabling stable and efficient transfer. A donor film is generally varied in its structure according to the type of object material, the physical properties of a layer including the object material, and the type of energy source used for transfer.

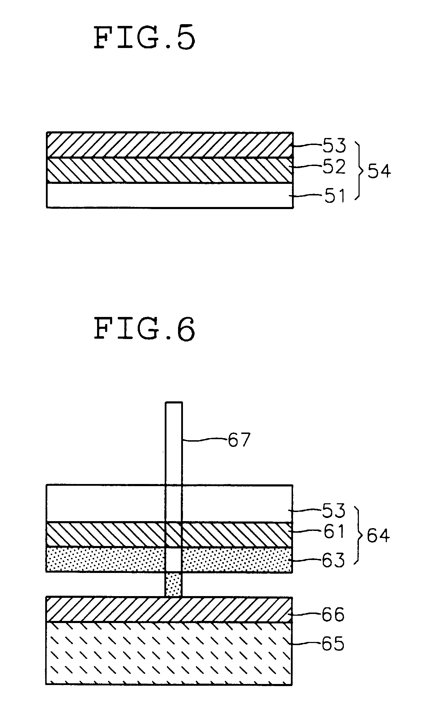

As shown in FIG. 5, the donor film according to the present invention has a structure in which a light-absorbing layer 52 and a transfer layer 53 are formed on a base film 51 in sequence. Based on this basic structure, various modifications can be achieved. That is, the structure of the donor film may be changed according to usage. For example, in order to prevent deterioration of characteristics of the transfer layer caused by reflection, an anti-reflection coating may be formed thereon. Also, in order to increase the sensitivity of the donor film, a gas producing layer may be included between the light-absorbing layer and the transfer layer.

The gas producing layer decomposes by absorbing light or heat to emit nitrogen or hydrogen gas, thus providing transfer energy. The gas producing layer is formed of pentaerythritol tetranitrate (PEPN) or trinitrotoluene (TNT).

In the donor film of the present invention, the base film is formed of a transparent polymer. The transparent polymer includes a polyester such as polyethyleneterephthalate, polyacryl, polyepoxy, polyethylene or polystylene. Here, preferably, polyethyleneterephthalate is used. The base film acts as a support for the donor film, and the preferable thickness of the base film is between 10~500µm.

The light-absorbing layer is formed of a light-absorption material which is capable of absorbing light of infrared to visible ranges. The light-absorbing layer may be a metal layer formed of aluminum, aluminum oxide and sulfide, or an organic layer formed of a polymer containing carbon black, graphite or infrared absorbing dye. Here, the metal layer is formed to a thickness of about 100∼5,000Å using a vacuum deposition method, an electron beam deposition method or a sputtering method. Meanwhile, preferably, the organic layer is formed to a thickness of about 0.1∼10µm by a general coating method such as an extrusion, spin or knife coating method.

As described above, the transfer layer is formed of at least one of a luminous material, a hole transport low/high molecular weight compound, and an electron transport low/high molecular weight compound. Here, the transfer layer is formed to a thickness of 100∼50,000Å by a general coating method such as an extrusion, spin or knife coating method, a vacuum deposition method or a chemical vapor deposition method.

In the case that a transfer layer is used for forming the emission layer of the organic EL device, the transfer layer is formed of a luminous material selected from the group consisting of an organic electroluminescence material, an organometallic complex electroluminescence material and an electroluminescence polymer. The luminous material includes compounds represented by the following formulae (1) through (7) .

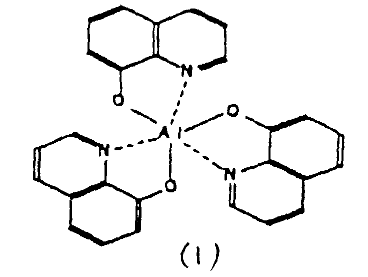

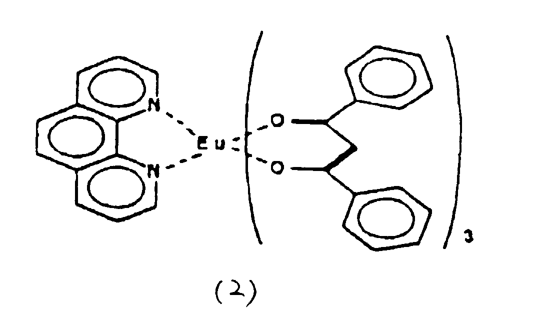

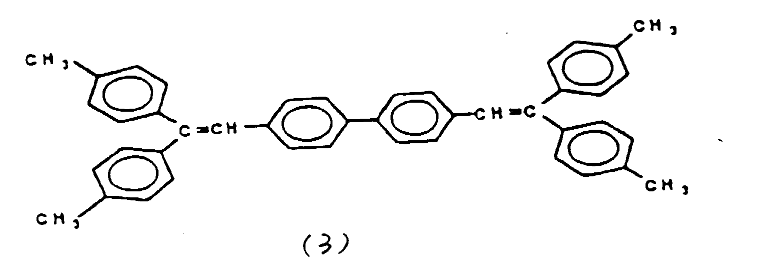

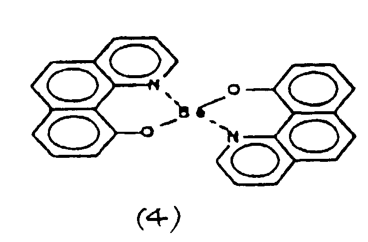

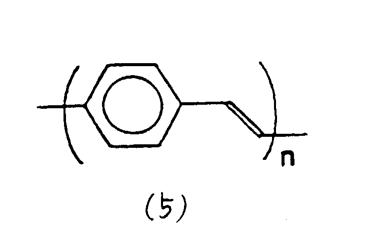

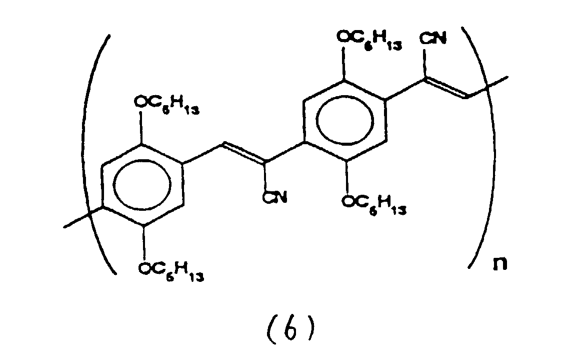

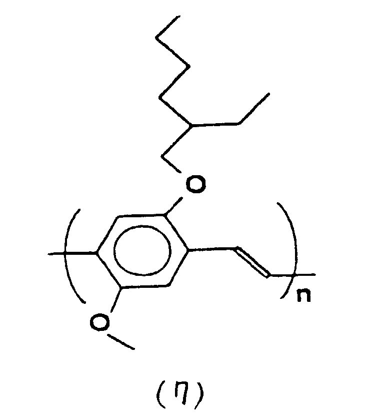

If the transfer layer is used to form the electron transport layer and the hole transport layer, the transfer layer is formed of a low molecular weight organic compound or a high molecular weight compound is used.

The electron transfer low molecular weight compound includes an 1,3,4-oxadiazole derivative and an 1,2,4-triazole (TAZ) derivative. Also, as the electron transfer high molecular weight compound, a polymer containing 1,2,4-triazole (TAZ) moiety is used.

The hole transfer low molecular weight compound includes aromatic amino derivatives represented by the following formulae (8) through (11).

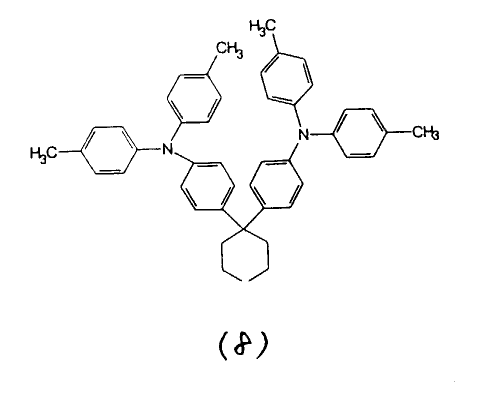

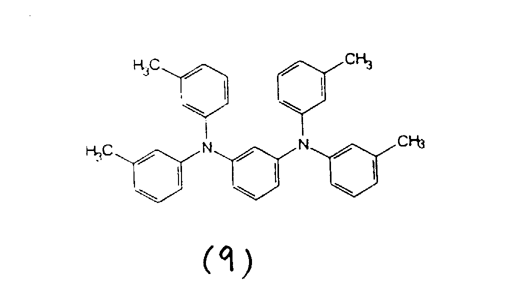

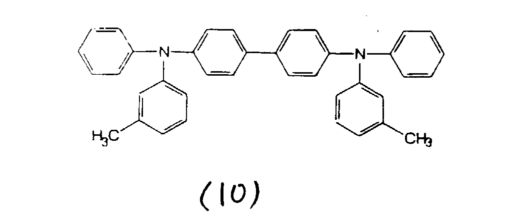

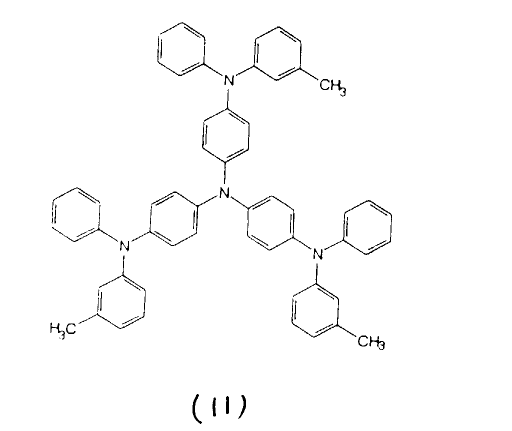

Preferably, a polymer having the formula (10) moiety at its main and side chains is used as the hole transfer high molecular weight compound, represented by the following formula (12). 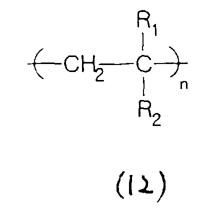 where R₁ is hydrogen or C₁∼C₁₀ alkyl, R₂ is selected from the group consisting 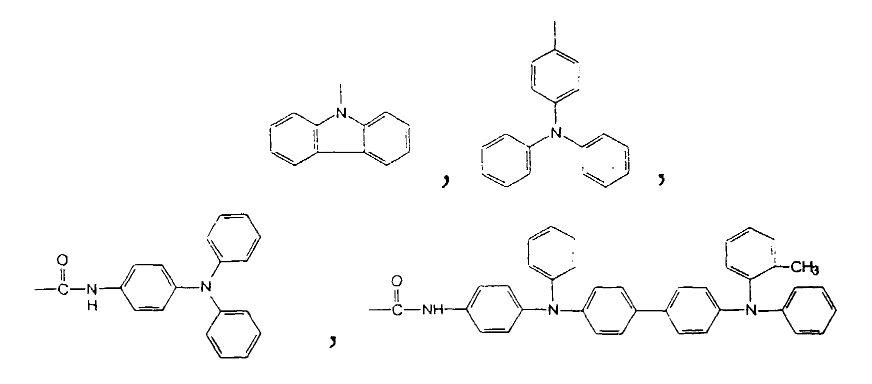 , and n is an integer from 3 to 50.

Among the above-described hole transport low molecular weight compounds, the electron transport low molecular weight compound, the hole transport high molecular weight compound and the electron transport high molecular weight compound, the high molecular weight compound is prefered over the low molecular weight compound in view of film forming properties.

Hereinafter, referring to FIG.6, a method for forming a fine pattern for an organic thin film of an organic EL device according to the present invention, and a method for manufacturing an EL device using the same will be described.

First, a first electrode layer 66 is formed on a transparent substrate 65. Then, a light-absorbing layer 62 and a transfer layer 63 are sequentially deposited on a base film 61 to form a donor film 64.

Here, the transfer layer 63 contains material for an organic thin film such as electron transport layer, hole transport layer or emission layer. Here, in order to enhance characteristics of the organic thin film, a predetermined amount of additives may be used. For example, a dopant may be added to enhance the efficiency of the emission layer. Also, the transfer layer is formed by the above-described general method such as an extrusion, spin or knife coating method.

In the case that an organic thin film is required for manufacturing a modified electron EL device, i.e., the electron transfer emission layer, materials for the electron transfer layer and the emission layer are dissolved in the same solvent, and the obtained dispersion is used therefor. Also, the hold transfer emission layer is formed of the mixture of materials for the hole transfer layer and the emission layer.

Then, the donor film 64 is arranged, separated by a predetermined distance from the substrate 65 having the transparent electrode layer 66, and a light source 67 is irradiated onto the donor film 64.

The light source 67 activates the light-absorbing layer 62 via a transfer device and the base film 63 in sequence, and the light-absorbing layer 62 emits heat through a light heat conversion mechanism; and by the emitted heat, the transfer material of the transfer layer 63 is transferred onto the transparent electrode layer 66 formed on the transparent substrate 65.

The light source used in the present invention may be a laser, a xenon (Xe) lamp or a flash lamp. Among the light sources, the laser is preferred due to its excellent transfer effect. Here, any commonly used laser beam may be used.

After the above transfer process, a thermal process may be performed to remove solvents included in the trnsfer material.

Here, the transfer of the transfer material may be performed by a single or multiple steps. That is, the organic thin film can be obtained by performing the transfer process once or several times to a desired thickness. However, in consideration of convenience and reliability, the transfer process is preferably performed only once.

After forming the organic thin films such as the hole transfer layer, the emission layer and the electron transfer layer according to the above method, a second electrode layer and an insulation film is then formed thereon, resulting in the organic EL device shown in FIGs. 1A, 1B and 1C.

Hereinafter, examples of the present invention will be described in detail. However, the present invention is not limited to the following examples.

### Example 1

A composition containing 20wt% Nichigo polyester LP-011 solution in methylethylketone, carbon black and methylethylketone in a ratio of 300:10:327 based on weight, was coated on a PET film having a thickness of about 200µm, resulting in a light-absorbing layer having a thickness of about 3µm.

Then, a composition obtained by dissolving poly(2-methoxy-5- (2-ethylhexyloxy)-1,4-phenylenevinylidene) (MEH-PPV) in tetrahydrofuran (THF) was coated on the light-absorbing layer to form a transfer layer to a thickness of about 500Å, thereby completing the donor film.

After arranging the donor film in a position separated a predetermined distance from a substrate having a transparent electrode, light was irradiated onto the PET film of the donor film to form an emission layer on the substrate. Here, the light source was an 8W Nd-Yag laser of approximately 100µm(l/e²) in beam size.

### Example 2

A light-absorbing layer having a thickness of approximately 1,000Å was formed by depositing black aluminum on a PET film having a thickness of 200µm. Then, a composition obtained by dissolving the compound represented by the formula (6) in THF was extrusion-coated on the light-absorbing layer to form a transfer layer, thereby completing the donor film.

The donor film was arranged in a position separated a predetermined distance rom a substrate having a transparent electrode layer, and then light was irradiated onto the PET film of the donor film to form an emission layer on the substrate. Here, the light source was an 8W Nd-Yag laser of approximately 100µm(l/e²)in beam size.

Then, the pattern of the emission layer formed in Examples 1 and 2 were examined using a scanning electron microscope (SEM) .

As the result, according to Examples 1 and 2, fine patterns having a pixel pitch of approximately 95µm can be obtained while the pattern formed by the conventional method has a pixel pitch of approximately 300µm.

According to the present invention, excellent organic thin films for the organic EL device, having fine patterns, can be formed. In addition, fine patterns of red, green and blue pixels can be formed, thereby providing full color displaying and a high quality organic EL device.

## Claims

1. A donor film for an organic thin film of an organic electroluminescence (EL) device, comprising:
a base film;
a light-absorbing layer formed on the base film; and
a transfer layer formed on the light-absorbing layer,
wherein the transfer layer is formed of at least one material selected from the group consisting of a luminous material, a hole transfer low molecular weight compound, a hole transfer high molecular weight compound, an electron transfer low molecular weight compound and an electron transfer high molecular weight compound, the luminous material being selected from the group consisting of an organic electroluminescence material, an organometallic complex electroluminescence material and an electroluminescence polymer.

2. The donor film of claim 1, wherein the luminous material is at least one selected from the group consisting of compounds represented by the following formulas (1) through (7):

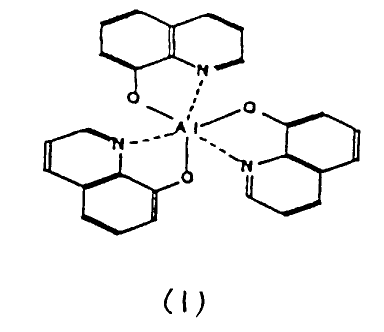

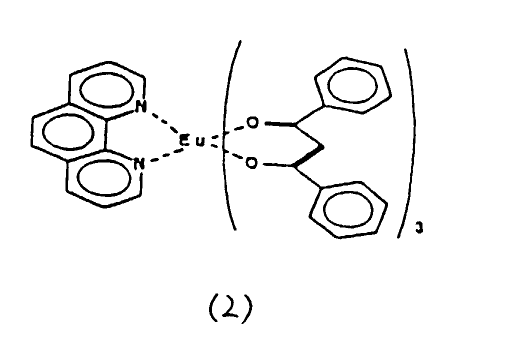

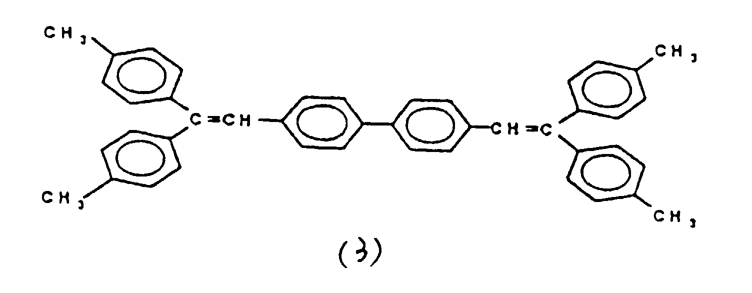

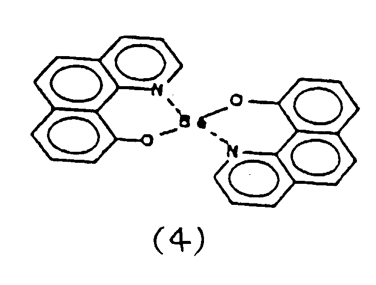

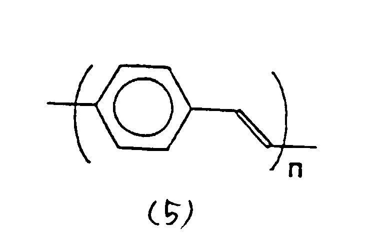

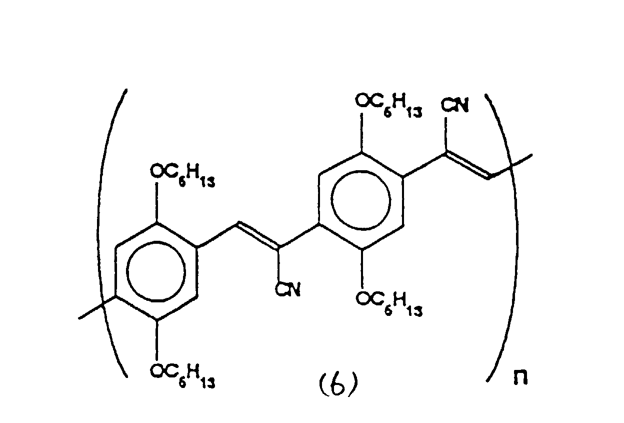

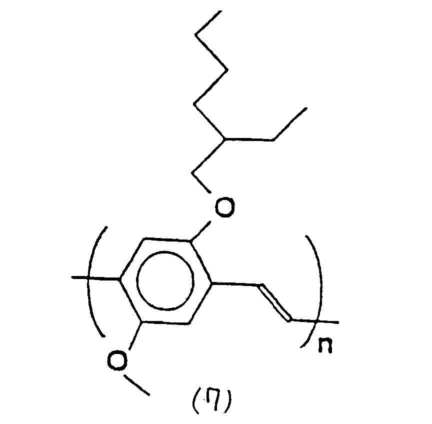

3. The donor film of claim 1, wherein the electron transport low molecular weight compound is at least one selected from the group consisting of an 1,3,4-oxadiazole derivative and an 1,2,4-triazole (TAZ) derivative.

4. The donor film of claim 1, wherein the electron transport high molecular weight compound is a polymer containing an 1,2,4-triazole (TAZ) moity.

5. The donor film of claim 1, wherein the hole transport low molecular weight compound is at least one selected from the group consisting of compounds represented by the following formulas (8) through (11):

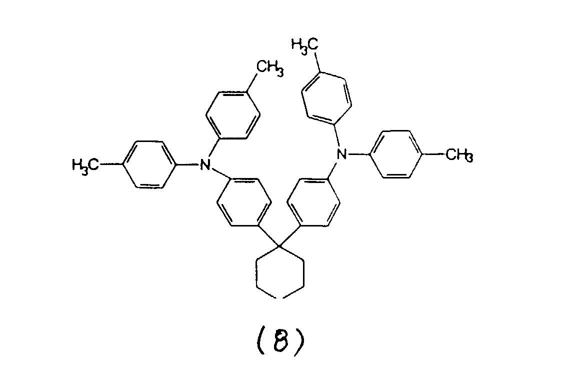

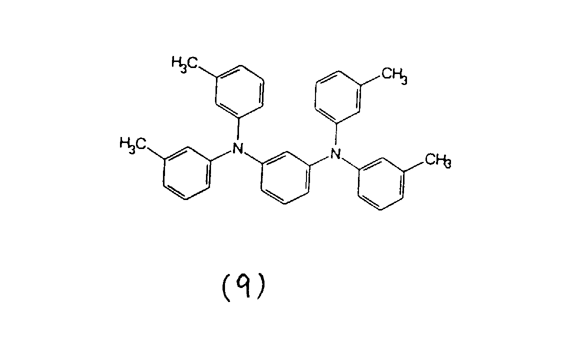

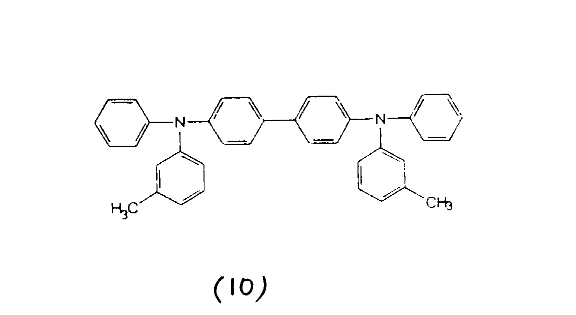

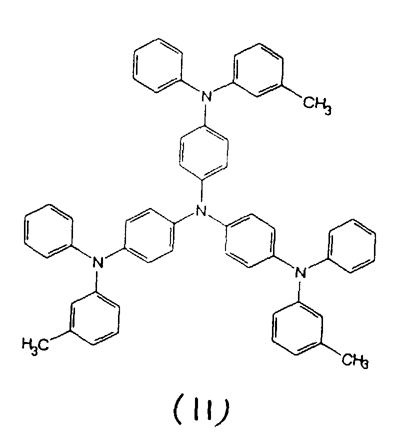

6. The donor film of claim 1, wherein the hole transport high molecular weight compound is represented by the following formula (12): 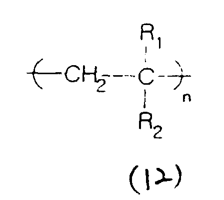 where R₁ is selected from the group consisting of hydrogen and C₁∼C₁₀ alkyl, R₂ is selected from the group consisting, 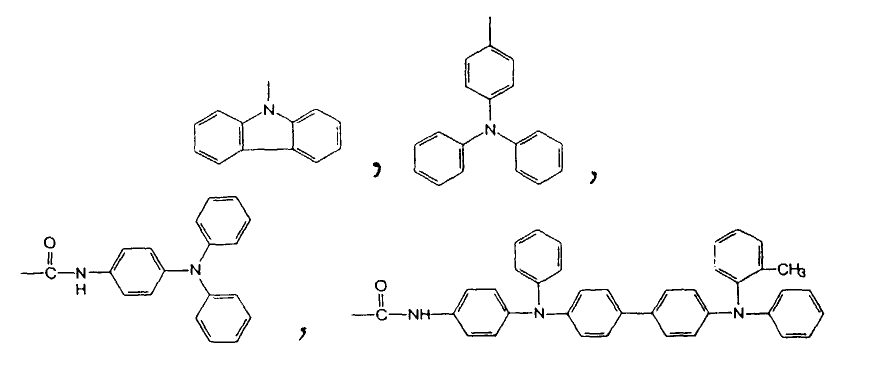 and n is an integer from 3 to 50.

7. The donor film of claim 1, further comprising a gas producing layer between the light-absorbing layer and the transfer layer.

8. The donor film of claim 7, wherein the gas producing layer is formed of at least one material selected from the group consisting of pentaerythritol tetranitrate (PEPN) and trinitrotoluene (TNT) .

9. A method for manufacturing an organic electroluminescence (EL) device, comprising the steps of:
(a) forming a first electrode layer on a substrate;
(b) arranging a donor film comprising a base film, a light-absorbing layer and a transfer layer in a position separated by a predetermined distance from the substrate having the first electrode layer, the transfer layer being formed of at least one transfer material selected from the group consisting of a luminous material, a hole transfer low molecular weight compound, a hole transfer high molecular weight compound, an electron transfer low molecular weight compound and an electron transfer high molecular weight compound, the luminous material being selected from the group consisting of an organic electroluminescence material, an organometallic complex electroluminescence material and an electroluminescence polymer;
(c) irradiating a light source onto the base film of the donor film to transfer at least one transfer material onto the substrate from the transfer layer, to form an objective layer corresponding to the selected transfer material; and
(d) forming a second electrode layer on the resultant.

10. The method of claim 9, wherein the luminous material is at least one selected from the group consisting of compounds represented by the following formulas (1) through (7):

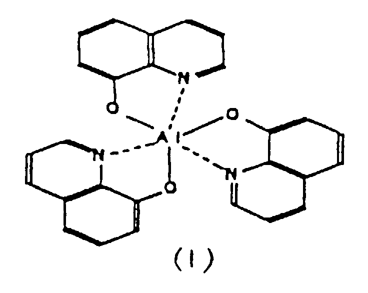

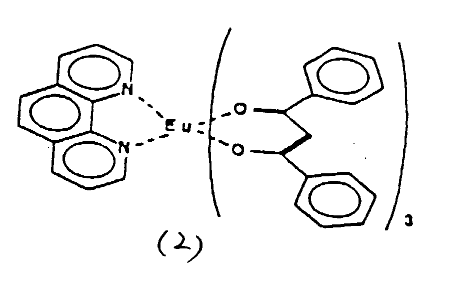

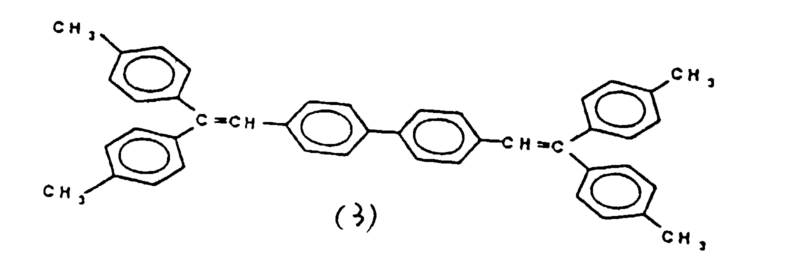

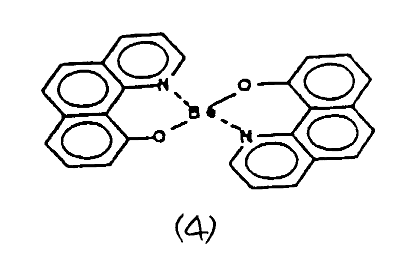

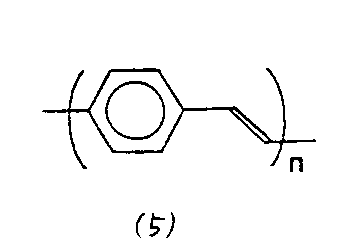

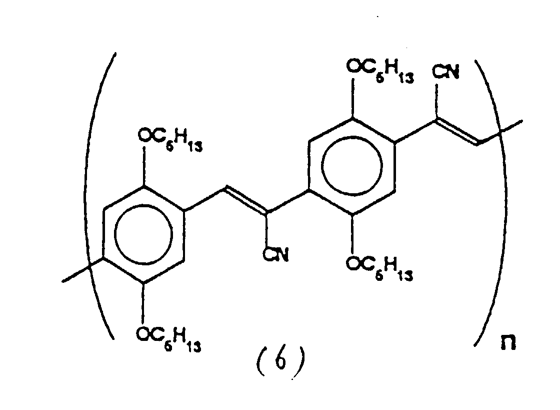

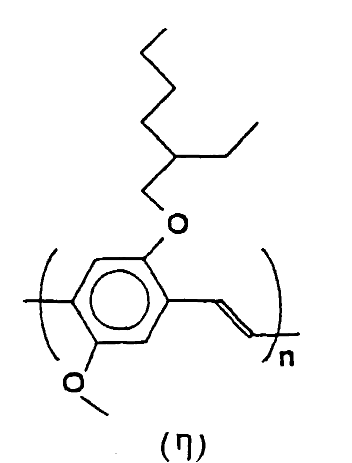

11. The method of claim 9, wherein the electron transport low molecular weight compound is at least one selected from the group consisting of an 1,3,4-oxadiazole derivative and an 1,2,4-triazole (TAZ) derivative.

12. The method of claim 9, wherein the electron transport high molecular weight compound is a polymer containing an 1,2,4-triazole (TAZ) moity.

13. The method of claim 9, wherein the hole transport low molecular weight compound is at least one selected from the group consisting of compounds represented by the following formulas (8) through (11):

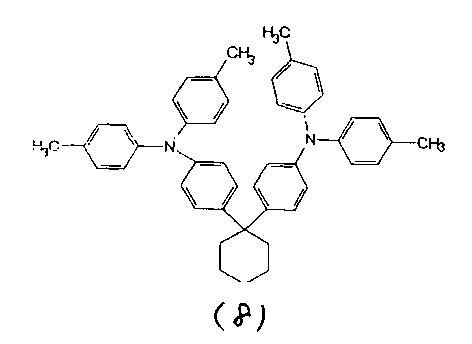

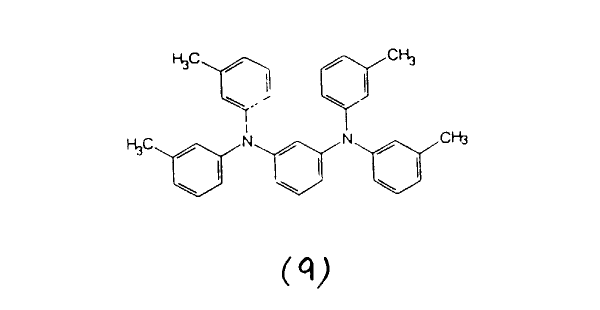

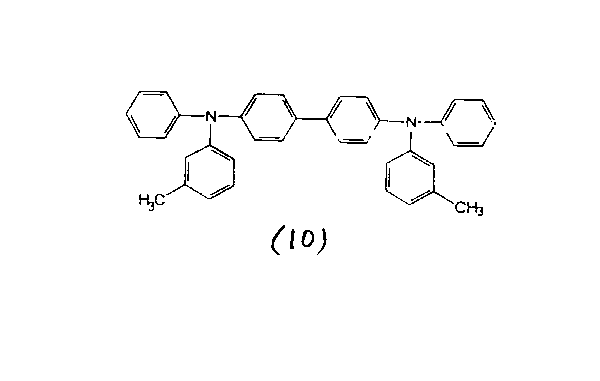

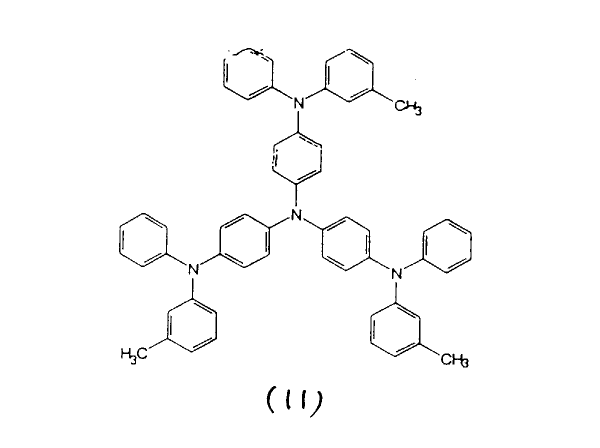

14. The method of claim 9, wherein the hole transport high molecular weight compound is represented by the following formula (12): 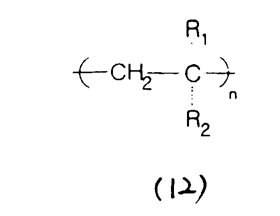 where R₁ is selected from the group consisting of hydrogen and C₁∼C₁₀ alkyl, R₂ is selected from the group consisting, 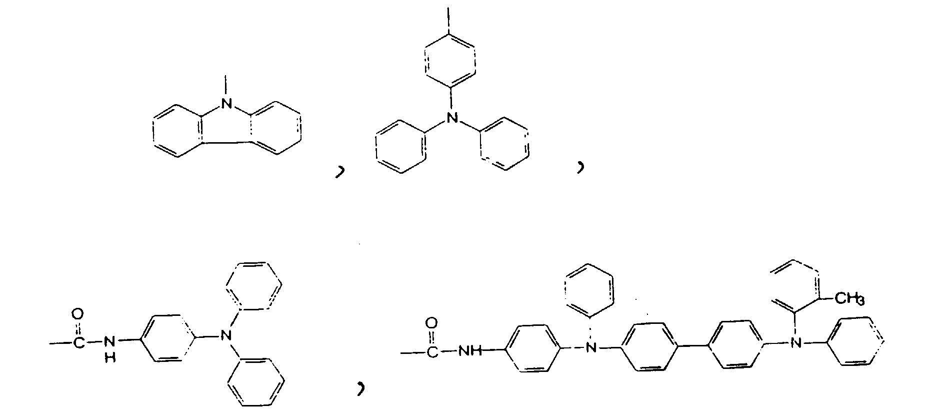 and n is an integer from 3 to 50.

15. The method of claim 9, further comprising a gas producing layer between the light-absorbing layer and the transfer layer.

16. The method of claim 9, wherein the gas producing layer is formed of at least one material selected from the group consisting of pentaerythritol tetranitrate (PEPN) and trinitrotoluene (TNT).
